# EUROPEAN PATENT APPLICATION

(11) **EP 2 166 132 A2**
(43) Date of publication of application: **24.03.2010**
(21) Application number: 09003684.9
(22) Date of filing: 13.03.2009
(51) Int. Cl.: C23C 28/00, C08J 7/04, H01L 51/52

(54) **Transparent conductive film and method for production thereof**

(30) Priority: 13.05.2008 JP 2008125923; 06.11.2008 JP 2008285729
(71) Applicant: Nitto Denko Corporation, Ibaraki-shi, Osaka 567-8680 (JP)
(72) Inventor: Sasa, Kazuaki, Ibaraki-shi Osaka, 567-8680 (JP)
(74) Representative: Grünecker, Kinkeldey, Stockmair & Schwanhäusser Anwaltssozietät

(57) **Abstract**

the transparent conductive film of the present invention is a transparent conductive film, comprising: an organic polymer film substrate; a first oxide thin film with a high visible-light transmittance formed on the organic polymer film substrate; and a ZnO-based transparent conductive thin film formed on the first oxide thin film, wherein the first oxide thin film has an oxygen content corresponding to 60 to 90% of the stoichiometric value before the ZnO-based transparent conductive thin film is formed. The transparent conductive film exhibits low resistance even when the ZnO-based transparent conductive thin film is relatively thin (particularly 100 nm or less in thickness), and has a low rate of change in resistance value even under a humidification and heating environment.

## Description

### BACKGROUND OF THE INVENTION

### Field of the Invention

The present invention relates to a transparent conductive film that includes an organic polymer film substrate and a method for producing the same. For example, the transparent conductive film of the invention may be used in electrode applications such as transparent electrodes for touch panels and electrodes for film solar cells and other applications including transparent electrodes for advanced display devices such as liquid crystal displays and electroluminescent displays and electromagnetic wave shielding or prevention of static charge of transparent products.

### Description of the Related Art

Recently, demanded types of touch panels, liquid crystal display panels, organic electroluminescent (OLED) panels, electrochromic panels, electronic paper devices, and so on are being changed from conventional devices using transparent electrode-attached glass substrates to devices using film substrates in which transparent electrodes are provided on transparent plastic films. At present, the dominating transparent electrode materials are ITO thin films, but In, a main component of ITO, has a depletion problem. Thus, attention has focused on transparent conductive ZnO-based films which are rich in resources.

The dominating ZnO-based thin films for use in transparent electrodes are GZO films made of Ga-doped ZnO and AZO films made of Al-doped ZnO. Methods for producing these films that have been examined include magnetron sputtering, pulsed laser deposition (PLD), reactive plasma deposition (RPD), and spray techniques. The properties of the ZnO-based thin films obtained by such methods have gradually approached those of ITO films, and their good specific resistance values of the order of 10⁻⁵ Ω·cm are also reported. Their durability such as heat resistance and resistance to moisture and heat has also gradually approached that of ITO films. In most of the reports, however, ZnO-based thin films are formed on heat-resistant substrates such as glass plates at a high temperature of about 300°C, and the examined ZnO-based thin films have thicknesses in the range of 200 to 500 nm, which are considerably thick.

On the other hand, the use of general-purpose organic polymer film substrates as the substrate on which the ZnO-based conductive film is formed has also been studied, but, generally, such organic polymer film substrates can be heated at a temperature of up to 180°C. When about 100 nm-thick ZnO-based conductive films are formed on such substrates whose temperature is set at 180°C or lower, only films that are higher in specific resistance than thick conductive films with a thickness of 200 nm or more and highly variable in resistance during a humidification and heating test are obtained (see Non-Patent Document 1).

Particularly when a ZnO-based transparent conductive film is produced by sputtering with a target of an oxide such as AZO or GZO at a substrate temperature of 180°C or less, an oxygen-excessive film is formed even though only Ar gas is used as the sputtering gas, because the oxide target contains a large amount of oxygen. In this process, therefore, only films whose specific resistance is high and whose resistance is highly variable in a humidification and heating test are obtained.

It is also proposed that in the process of forming an AZO film on an organic polymer film substrate (such as a polyethylene terephthalate substrate (PET substrate)), a glass-like layer (Al₂O₃ film) should be provided between the PET substrate and the AZO film to reduce the specific resistance (see Non-Patent Document 2).

Non-Patent Document 1: Proceedings of the 67th Meeting of the Japan Society of Applied Physics, 31p-ZE-8, "Thickness Dependency of Moisture Proof of Electrical Characteristics of ZnO-Based Transparent Conductive Films"
Non-Patent Document 2: Proceedings of the 67th Meeting of the Japan Society of Applied Physics, 31p-ZE-19, "Zinc Oxide-Based Transparent Conductive Film Formed on PET Substrate by PLD Method"

### SUMMARY OF THE INVENTION

The glass-like layer (aluminum oxide film) of Non-Patent Document 2 is produced by PLD method with an aluminum oxide material having a stoichiometric oxygen content and has to have a smooth surface and a thickness of 200 nm or more. In addition, the glass-like layer is effective only when the AZO film formed thereon is relatively thick (225 nm).

It has also been found that when a ZnO-based transparent conductive thin film is formed on an organic polymer film substrate, the electrical resistance and the moisture and heat resistance of the transparent conductive thin film are degraded by gas such as oxygen and water generated from the film substrate. Specifically, donors are formed in an oxygen-poor transparent conductive thin film. However, when an excess amount of oxygen is incorporated into the film, donors decrease so that the electron density decreases and that the resistance value increases. Further, when the number of oxygen holes is small, the atoms are not well rearranged or crystallized through the holes so that the resistance value or the moisture and heat resistance can be degraded. Particularly when a ZnO-based transparent conductive thin film with a thickness of 100 nm or less is formed, this influence is significant.

An object of the invention is to provide a transparent conductive film that includes an organic polymer film substrate and a ZnO-based transparent conductive thin film, exhibits low resistance even when the ZnO-based transparent conductive thin film is relatively thin (particularly 100 nm or less in thickness), and has a low rate of change in resistance value even under a humidification and heating environment, and to provide a method for producing such a transparent conductive film.

As a result of active investigations for achieving the above objects, the inventors have found that the above objects can be achieved with the transparent conductive film and the method for producing the same as described below so that the invention has been completed.

Namely, the transparent conductive film of the present invention is a transparent conductive film, comprising: an organic polymer film substrate; a first oxide thin film with a high visible-light transmittance formed on the organic polymer film substrate; and a ZnO-based transparent conductive thin film formed on the first oxide thin film, wherein the first oxide thin film has an oxygen content corresponding to 60 to 90% of the stoichiometric value before the ZnO-based transparent conductive thin film is formed.

As used herein, the term "high visible-light transmittance" means a visible-light transmittance of 80% or more as measured according to JIS K 7361.

The transparent conductive film of the invention includes an organic polymer film substrate, a ZnO-based transparent conductive thin film, and a first oxide thin film that is interposed between the organic polymer film substrate and the ZnO-based transparent conductive thin film and has an oxygen content corresponding to 60 to 90% of the stoichiometric value before the ZnO-based transparent conductive thin film is formed. According to such a structure, the first oxide thin film serving as a ground is presumed to be in such a state that it can absorb oxygen in the process of forming the ZnO-based transparent conductive thin film so that the ZnO-based transparent conductive thin film can be formed in an oxygen-poor state, even when an oxygen-excessive oxide target is used to form the ZnO-based transparent conductive thin film. Therefore, even when the ZnO-based transparent conductive thin film is 100 nm or less in thickness, it can exhibit a low resistance value, and the atoms can be well rearranged or crystallized, so that it can have a low rate of change in resistance value even under a humidification and heating environment and have a high level of resistance to moisture and heat. When the oxide thin film has an oxygen content corresponding to less than 60% of the stoichiometric value before the ZnO-based transparent conductive thin film is formed, the film formation can be unstable, and the light absorption can increase to cause a reduction in visible-light transmittance. Such an oxide film can be unsuitable for use in transparent conductive film applications.

The oxygen content of the first oxide thin film preferably corresponds to 60 to 90% of the stoichiometric value, more preferably 65 to 75% of the stoichiometric value. In this range, the resistance value can be further reduced, while the transparency is ensured. In this range, the rate of change in resistance value under a humidification and heating environment can be further reduced.

The resistance (R₁) of the ZnO-based transparent conductive thin film after heating in air at 150°C for 1 hour is preferably 10% or more, more preferably 20% or more, even more preferably 20 to 40% lower than the resistance (R₀) of the ZnO-based transparent conductive thin film immediately after it is formed on the first oxide thin film. In this range, the ZnO-based transparent conductive thin film can be formed in an oxygen-poor state, exhibit a low resistance value, and have a low rate of change in resistance value even under a humidification and heating environment. For example, a process for controlling the rate of resistance change in the above range may include: forming, on the organic polymer film substrate, the first oxide thin film with an oxygen content corresponding to 60 to 90% of the stoichiometric value by a reactive dual magnetron sputtering method, while controlling the impedance with a plasma emission monitor controller (PEM) so that the controlled impedance value (set point (SP)) can be set in a specific range as described later; and then forming the ZnO-based transparent conductive thin film on the first oxide thin film as described later.

The ZnO-based transparent conductive thin film is preferably a ZnO thin film doped with one or more elements selected from Al, Ga, B, and In. It is because the transparency and the electrical conductivity can be easily improved with such a thin film.

The first oxide thin film is preferably an aluminum oxide thin film or a silicon oxide thin film, because such a thin film can provide a satisfactory level of low refractive index, low internal stress, high productivity, high moisture-proof, and compatibility with the ZnO-based thin film.

In an embodiment of the invention, a second oxide thin film with high visible-light transmittance may be further provided on the ZnO-based transparent conductive thin film. The second oxide thin film can serve as an overcoat layer to protect the ZnO-based transparent conductive thin film.

The second oxide thin film preferably has a water-vapor transmission rate of 1.0 g/m² per day or less, more preferably 0.5 g/m² per day or less, as measured by MOCON method under the conditions of an atmosphere temperature of 40°C and a relative humidity of 90%. When the thickness of the ZnO-based transparent conductive thin film is 100 nm or less, moisture in air or moisture during a humidification and heating test can intrude through the surface or crystal grains of the ZnO-based transparent conductive thin film so that the moisture could inhibit the electron transfer or reduce the electron density. Therefore, it is considered that when the second oxide thin film having a low water-vapor transmission rate (having moisture barrier properties) as described above is used as an overcoat layer, the adsorption of water to the surface or inside of the ZnO-based transparent conductive thin film can be prevented so that improvements in resistance value and moisture and heat-resistant reliability can be provided. In addition, when an oxide having an oxygen content lower than the stoichiometric value is used as a material for the second oxide thin film, the resistance value of the ZnO-based transparent conductive thin film can be further reduced.

The ZnO-based transparent conductive thin film preferably has a thickness of 10 to 100 nm. It is because the visible-light transmittance can be improved with such a thin film, while flatness is ensured. In this range, the productivity can also be improved.

The invention is also directed to a suitable method for producing the transparent conductive film of the invention, which includes forming the first oxide thin film by a reactive dual magnetron sputtering method. The use of a reactive dual magnetron sputtering method to form the film can not only prevent damage to the substrate but also improve the deposition rate. In addition, the oxygen content of the first oxide thin film can be easily controlled by this method.

### BRIEF DESCRIPTION OF DRAWINGS

Fig. 1 is a schematic cross-sectional view showing an example of the transparent conductive film of the invention;
Fig. 2 is a schematic cross-sectional view showing another example of the transparent conductive film of the invention; and
Fig. 3 is an AFM photograph showing the surface of aluminum oxide thin films.

### DETAILED DESCRIPTION OF THE PREFERRED EMBODIMENTS

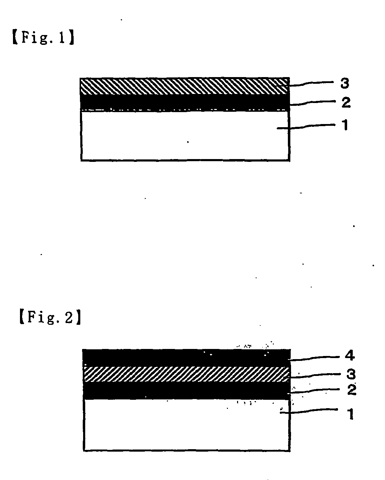

Some embodiments of the invention are described below with reference to the drawings. Fig. 1 is a schematic cross-sectional view showing an example of the transparent conductive film of the invention. Fig. 2 is a schematic cross-sectional view showing another example of the transparent conductive film of the invention.

The transparent conductive film shown in Fig. 1 includes an organic polymer film substrate 1 and a first oxide thin film 2 with high visible-light transmittance and a ZnO-based transparent conductive thin film 3 which are sequentially formed on the organic polymer film substrate 1. Further, before the ZnO-based transparent conductive thin film 3 is formed, the first oxide thin film 2 has an oxygen content corresponding to 60 to 90% (preferably 65 to 75%) of the stoichiometric value. Furthermore, the transparent conductive film shown in Fig. 2 includes the same structure as the transparent conductive film of Fig. 1 and further includes a second oxide thin film 4 with high visible-light transmittance formed on the ZnO-based transparent conductive thin film 3.

The organic polymer film substrate 1 for use in the invention is preferably excellent in transparency, heat resistance and surface smoothness. Examples of materials for such a film substrate include polyester-based polymers such as polyethylene terephthalate and polyethylene naphthalate, polyolefin-based polymers, polycarbonate, polyethersulfone, polyarylate, polyimide, and polymers of a single component such as norbornene and the like or copolymers thereof. An epoxy-based film and the like may also be used as the organic polymer film substrate.

The thickness of the organic polymer film substrate 1 is generally from about 16 to about 200 µm, depending on the film formation conditions or the usage. The thickness for improvement in transparency with ensured mechanical strength is preferably from 25 to 125 µm.

Preferably, the surface of the organic polymer film substrate 1 is smooth and has no irregularities. Therefore, the surface of the organic polymer film substrate 1 where the first oxide thin film 2 will be formed preferably has a surface roughness (Ra) of 1.5 nm or less per 1 µm square as measured with an atomic force microscope (AFM).

Aluminum oxide, silicon oxide, cerium oxide, niobium oxide, titanium oxide, or the like may be used to form the first oxide thin film 2. In view of low refractive index, low internal stress, high productivity, high moisture proof, or compatibility with the ZnO-based transparent conductive thin film 3, aluminum oxide or silicon oxide is preferably used.

The thickness of the first oxide thin film 2 is typically from 2 to 100 nm, preferably from 4 to 50 nm. This range allows not only the establishment of flatness but also improvements in visible-light transmittance and productivity.

While a variety of film forming methods may be used to form the first oxide thin film 2 on the organic polymer film substrate 1, vacuum film-forming methods are preferably used, because the content of oxygen in the first oxide thin film 2 can be freely controlled by such methods. In particular, a reactive dual magnetron sputtering method including producing a film with a target substantially free of oxygen under an atmosphere of a gas mixture of oxygen and an inert gas such as argon gas is preferred in view of an improvement in film forming rate, a reduction in damage to the substrate, and controllability of the oxygen content of the first oxide thin film 2.

In addition, before the first oxide thin film 2 is formed on the organic polymer film substrate 1, surface modification treatment (pretreatment) such as plasma treatment may be performed on the organic polymer film substrate 1 under an atmosphere of an inert gas such as argon gas or nitrogen gas.

In a reactive dual magnetron sputtering method, two target pieces fixed on the respective magnet electrodes are alternately used for electric discharge with a medium frequency (MF) power source. In this method, one target is used for electric discharge to form a film, while a weak reverse charge is applied to the other target to cancel the charge of the target surface, so that the film can be stably produced even when the target surface conduction is not good due to an oxide such as aluminum oxide or silicon oxide.

A case where an aluminum oxide thin film is formed by a reactive dual magnetron sputtering method is described below. A reactive dual magnetron sputtering method includes the step of producing an aluminum oxide thin film with a target of Al under an atmosphere of a gas mixture of oxygen and an inert gas such as argon gas. The supply of oxygen gas into the system is generally controlled by a plasma control method in which a plasma emission monitor controller (PEM) is used to detect the plasma intensity in the electric discharge so that the amount of the reactant gas (oxygen gas) being introduced can be feedback-controlled, or by an impedance control method in which a PEM is similarly used to detect the impedance of the electric discharge (the resistance value of the electric discharge) so that the amount of the introduction of oxygen gas can be changed to a specific constant value. The PEM system to be used may be PEM05 manufactured by Von Ardenne Anlagentechnik GmbH (Germany). This system may be used for both of the plasma control method and the impedance control method. The impedance control method is preferably used to form an aluminum oxide film, because it allows stable control.

When impedance control is performed with a PEM during film formation, the controlled impedance value (set point (SP)) may be changed so as to control the oxygen content of the resulting aluminum oxide thin film.

Aluminum oxide thin films were formed by a reactive dual magnetron sputtering method with different SPs (under the conditions of Example 1, except for SP). The thin films were then analyzed with an X-ray photoelectron analyzer (ESCA) according to a measurement method as described later, and the ratio of the oxygen peak value to the aluminum peak value (oxygen peak value/aluminum peak value, hereinafter referred to as "O/Al value") was calculated. Silicon oxide thin films were also formed by a reactive dual magnetron sputtering method with different SPs (under the conditions of Example 6, except for SP). The thin films were then analyzed by ESCA according to a measurement method as described later, and the ratio of the oxygen peak value to the silicon peak value (oxygen peak value/silicon peak value, hereinafter referred to as "O/Si value") was calculated. The results are shown in Table 1. In the stoichiometric composition of aluminum oxide (Al₂O₃), the O/Al value is 1.80. In the stoichiometric composition of silicon oxide (SiO₂), the O/Si value is 2.00. Further, in Table 1, the oxygen content (%) of the aluminum oxide thin film relative to the stoichiometric value is expressed by the ratio of the O/Al value of the aluminum oxide thin film to the O/Al value of the stoichiometric composition (Al₂O₃). Also in Table 1, the oxygen content (%) of the silicon oxide thin film relative to the stoichiometric value is expressed by the ratio of the O/Si value of the silicon oxide thin film to the O/Si value of the stoichiometric composition (SiO₂).

**[Table 1]**

| Aluminum Oxide Thin Film | | | Silicon Oxide Thin Film | | |
|---|---|---|---|---|---|
| SP | O/Al Value | Oxygen Content (%) Relative to Stoichiometric Value | SP | O/Si Value | Oxygen Content (%) Relative to Stoichiometric Value |
| 17 | 1.80 | 100 | 35 | 2.00 | 100 |
| 20 | 1.62 | 90 | 40 | 1.80 | 90 |
| 25 | 1.46 | 80 | 45 | 1.60 | 80 |
| 30 | 1.35 | 75 | 47.5 | 1.50 | 75 |
| 35 | 1.26 | 70 | 50 | 1.40 | 70 |
| 40 | 1.17 | 65 | 52.5 | 1.30 | 65 |
| 45 | 1.08 | 60 | 55 | 1.20 | 60 |

When an aluminum oxide thin film is formed by a reactive dual magnetron sputtering method, the film formation may be performed at an applied power of 3 kW under production conditions where SP is from 20 to 45 so that the oxygen content of the aluminum oxide thin film can be set in the range of 60 to 90% of the stoichiometric value (see Table 1). The film formation may also be performed at an applied power of 3 kW under production conditions where SP is from 30 to 40 so that the oxygen content of the aluminum oxide thin film can be set in the range of 65 to 75% of the stoichiometric value (see Table 1).

On the other hand, when a silicon oxide thin film is formed by a reactive dual magnetron sputtering method, the film formation may be performed at an applied power of 3 kW under production conditions where SP is from 40 to 55 so that the oxygen content of the silicon oxide thin film can be set in the range of 60 to 90% of the stoichiometric value (see Table 1). The film formation may also be performed at an applied power of 3 kW under production conditions where SP is from 47.5 to 52.5 so that the oxygen content of the silicon oxide thin film can be set in the range of 65 to 75% of the stoichiometric value (see Table 1).

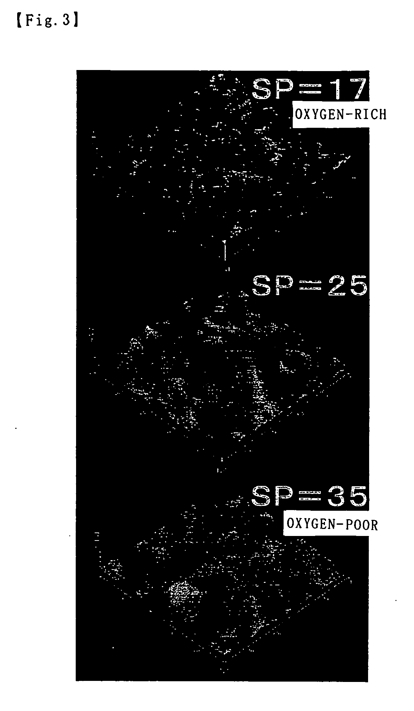

When the amount of the introduction of oxygen is changed in the process of forming the first oxide thin film 2 on the organic polymer film substrate 1, the surface irregularities of the first oxide thin film 2 is changed. For example, when an aluminum oxide thin film is formed at a SP of 17, its surface is significantly rough as shown in the AFM photograph of Fig. 3. However, when the film is formed at a SP of 25 to 35, large irregularities disappear, and the pitch of irregularities becomes small so that the smoothness can be entirely improved.

A vacuum film-forming method such as magnetron sputtering method, pulsed laser deposition (PLD) method, or reactive plasma deposition (RPD) method may be used to form the ZnO-based transparent conductive thin film 3. In particular, magnetron sputtering may generally be used in view of the properties of the resulting film and productivity.

For example, the method used to form the ZnO-based transparent conductive thin film 3 by magnetron sputtering may be any of the two methods described below. A method includes sputtering a film from a sintered oxide target under an argon gas atmosphere mainly composed of argon gas. Only argon gas or a gas mixture of argon gas and a small amount of hydrogen gas may be used for the argon gas atmosphere. Another method is a reactive magnetron sputtering method that includes sputtering a film from a metal target under an atmosphere of a gas mixture of oxygen and argon.

An advantage of the invention is that an oxygen-poor film can be formed in the process of producing a ZnO-based transparent conductive thin film 3 from a sintered oxide target. In an embodiment of the invention, even when a film is produced from a metal target with controlling the amount of oxygen, the ZnO-based transparent conductive thin film 3 can be formed on the first oxide thin film 2, whose surface smoothness is easy to control, so that the crystallinity of the ZnO-based transparent conductive thin film 3 can be improved. The advantage of providing the second oxide thin film 4 described later can be obtained both when the film is produced from a sintered oxide target and a metal target.

Particularly when the ZnO-based transparent conductive thin film 3 is formed with a thickness of 100 nm or less at low temperature (for example, about 100°C) on the organic polymer film substrate 1, the film can be like a polycrystal whose crystal orientation does not clearly become c-axis orientation but is deviated. In this case, moisture in air can intrude through the surface of the thin film or the interface of the polycrystal so that electrons can be less mobile and that the resistance can increase.

In such a case, the second oxide thin film 4 may be formed on the ZnO-based transparent conductive thin film 3, so that the ZnO-based transparent conductive thin film 3 can be protected from the moisture in air and so on. Particularly when the second oxide thin film 4 used has a water vapor transmission rate of 1.0 g/m² per day or less as measured by MOCON method under the conditions of an atmosphere temperature of 40°C and a relative humidity of 90%, it can provide more effective moisture-proof properties. Examples of the material that may be used to form the second oxide thin film 4 include the same materials as described for the first oxide thin film 2, ITO, and ITO mixed with any other element. Conductive materials such as ITO-based materials are preferably used, because they can produce low resistance.

The thickness of the second oxide thin film 4 is preferably from 1 to 100 nm, more preferably from 2 to 80 nm, in view of flatness and moisture-proof properties, while it depends on the component materials. When the second oxide thin film 4 is made of an insulating material for electrode applications, it is preferably a thin layer. When the second oxide thin film 4 is used for capacitive type touch panels, its thickness may be beyond the range. The second oxide thin film 4 may be formed by the same method as described for the first oxide thin film 2.

The transparent conductive film obtained as described above may be further subjected to an annealing process in which heat treatment at a temperature of 80 to 180°C is performed. Such a process can induce reorganization of the internal structure of the ZnO-based transparent conductive thin film 3. Such a process can also produce low resistance and improve resistance to moisture and heat. The annealing process is preferably performed under the conditions of a temperature of 130 to 160°C and a time of about 30 minutes to about 24 hours, more preferably under the conditions of the same temperature range and a time of 1 to 10 hours. The annealing process may be performed under reduced pressure or vacuum atmosphere, while it is generally performed in air.

The invention has been described above with an embodiment which is not intended to limit the scope of the invention. For example, the transparent conductive film of the invention may further include a thick transparent base material bonded through a transparent pressure-sensitive adhesive to the surface of the organic polymer film substrate opposite to the surface on which the films are formed. It is advantageous in that the mechanical strength of the film can be increased and that in particular, curling or the like can be prevented. For touch panel electrode applications, the cushion effect of the transparent pressure-sensitive adhesive can dramatically increase the mechanical durability of the ZnO-based transparent conductive thin film.

### EXAMPLES

The invention is more specifically described with the examples below which are not intended to limit the scope of the invention.

### Examples 1

### Organic Polymer Film Substrate

The organic polymer film substrate used was a polyethylene terephthalate (PET) film 0300E (100 µm in thickness) manufactured by Mitsubishi Plastics Inc.

### Pretreatment

The PET film was attached to a winding system equipped with a plasma treatment unit, one dual-magnetron sputtering electrode, and two single-magnetron sputtering electrodes. Degassing was performed with an evacuation system including a cryocoil and a turbopump to produce an ultimate vacuum of 1.5x10⁻⁶ Pa, while the PET film was wound by means of a roller electrode heated at 120°C. Argon gas was then introduced, and the PET film was allowed to pass through plasma discharge at 13.56 MHz so that the smooth surface on which films were to be deposited was pretreated.

### Formation of Aluminum Oxide Thin Film

A target of Al was then mounted on the dual magnetron sputtering electrode. While argon gas was introduced at 150 sccm (unit of air-equivalent gas flow rate), oxygen gas was introduced under PEM impedance control during MF discharge at 3 kW so that an aluminum oxide thin film was formed as the first oxide thin film (undercoat layer). The film was deposited under a pressure of 0.3 Pa, and the SP was set at 35. The resulting aluminum oxide thin film had a thickness of about 10 nm.

### Formation of GZO Thin Film

A ZnO-Ga₂O₃ target (5.7% by weight in Ga₂O₃ content) was then mounted on the single magnetron sputtering electrode, and film deposition was performed under a pressure of 0.3 Pa at an argon gas introduction rate of 300 sccm and a DC power of 3 kW. The resulting GZO thin film had a thickness of about 40 nm. As a result of the process described above, a transparent conductive film of Example 1 was obtained.

On the other hand, the same process was performed until the aluminum oxide thin film was formed, and then the resulting aluminum oxide thin film was analyzed by ESCA under the conditions described below so that the oxygen content relative to the stoichiometric value of the stoichiometric composition (Al₂O₃) was calculated as described above. The result is shown in Table 2. The undercoat layer in each of the Examples and the Comparative Examples below was also analyzed in the same manner, and the oxygen content of the aluminum oxide thin film or the silicon oxide thin film was calculated relative to the stoichiometric value of the stoichiometric composition (Al₂O₃ or SiO₂).

### Analysis Conditions for ESCA

ESCA system: Quantum 2000 manufactured by Ulvac-Phi, Incorporated
X-ray source: monochrome AlKα ray
Spot size: 200 µmφ
Photoelectron take-off angle: 45 degrees with respect to the sample surface

### Example 2

The process of Example 1 was performed until the GZO thin film was formed. Another aluminum oxide thin film (about 5 nm in thickness) was then formed as the second oxide thin film (overcoat layer) on the GZO thin film. The aluminum oxide thin film was formed by the same method as the undercoat layer in Example 1. The overcoat layer had a water-vapor transmission rate of 1.0 g/m² per day or less as measured by MOCON method under the conditions of an atmosphere temperature of 40°C and a relative humidity of 90%. In each example below using an overcoat layer, the second oxide thin film used had a water-vapor transmission rate of 1.0 g/m² per day or less.

### Example 3

The process of Example 1 was performed until the GZO thin film was formed. An ITO-silicon oxide thin film was then formed as an overcoat layer by the method described below.

### Formation of ITO-Silicon Oxide Thin Film

An In₂O₃-SnO₂-SiO₂ target (5% by weight in each of SnO₂ content and SiO₂ content) was mounted on the single magnetron sputtering electrode, and film deposition was performed under a pressure of 0.3 Pa at an argon gas introduction rate of 300 sccm and a DC power of 3 kW. The resulting ITO-silicon oxide thin film had a thickness of about 20 nm.

### Example 4

The process of Example 1 was performed until the aluminum oxide thin film was formed. An AZO thin film was then formed on the aluminum oxide thin film by the method described below.

### Formation of AZO Thin Film

A ZnO-Al₂O₃ target (3.0% by weight in Al₂O₃ content) was mounted on the single magnetron sputtering electrode, and film deposition was performed under a pressure of 0.3 Pa at an argon gas introduction rate of 300 sccm and a DC power of 3 kW. The resulting AZO thin film had a thickness of about 40 nm.

### Example 5

The process of Example 4 was performed until the AZO thin film was formed, and then an aluminum oxide thin film was formed as an overcoat layer in the same manner as in Example 2.

### Example 6

The process of Example 1 was performed until the pretreatment, and then a silicon oxide thin film was formed as an undercoat layer by the method described below.

### Formation of Silicon Oxide Thin Film

A Si target was mounted on the dual magnetron sputtering electrode. While argon gas was introduced at 150 sccm, oxygen gas was introduced under PEM impedance control during MF discharge at 3 kW so that a silicon oxide thin film was formed. The film was deposited under a pressure of 0.3 Pa, and the SP was set at 50. The resulting silicon oxide thin film had a thickness of about 10 nm. A GZO thin film was formed thereon by the same method as in Example 1.

### Example 7

The process of Example 6 was performed until the GZO thin film was formed, and then a silicon oxide thin film was formed thereon as an overcoat layer. The silicon oxide thin film was formed by the same method as the undercoat layer in Example 6. The silicon oxide thin film serving as an overcoat layer had a thickness of about 5 nm.

### Example 8

The process of Example 6 was performed until the silicon oxide thin film (undercoat layer) was formed, and then an AZO thin film was formed on the silicon oxide thin film by the same method as in Example 4.

### Example 9

The process of Example 8 was performed until the AZO thin film was formed, and then a silicon oxide thin film was formed as an overcoat layer by the same method as in Example 7.

### Example 10

A transparent conductive film was obtained using the process of Example 2, except that the SP was set at 25 when the undercoat layer and the overcoat layer were formed.

### Example 11

A transparent conductive film was obtained using the process of Example 7, except that the SP was set at 45 when the undercoat layer and the overcoat layer were formed.

### Comparative Example 1

A transparent conductive film was obtained using the process of Example 1, except that the undercoat layer was not formed.

### Comparative Example 2

A transparent conductive film was obtained using the process of Example 4, except that the undercoat layer was not formed.

### Comparative Example 3

A transparent conductive film was obtained using the process of Example 1, except that the SP was set at 17 when the aluminum oxide thin film was formed.

### Comparative Example 4

A transparent conductive film was obtained using the process of Example 4, except that the SP was set at 17 when the aluminum oxide thin film was formed.

### Comparative Example 5

A transparent conductive film was obtained using the process of Example 6, except that the SP was set at 35 when the silicon oxide thin film was formed.

### Comparative Example 6

A transparent conductive film was obtained using the process of Example 8, except that the SP was set at 35 when the silicon oxide thin film was formed.

The transparent conductive film obtained in each of the Examples and the Comparative Examples was evaluated as described below. The results are shown in Table 2.

### Initial Resistance Value

The initial resistance value Ro (Ω/square) of each transparent conductive film was measured with Loresta (MCP-P600 model) manufactured by Mitsubishi Chemical Corporation.

### Resistance to Moisture and Heat

The resistance values (R₁ and R₁₀) of each transparent conductive film were measured with the Loresta after it was stored in air at 150°C for 1 hour and after it was stored in air at 150°C for 10 hours, respectively. The samples were also placed in a thermo-hygrostat at 85°C and 85%RH for 250 hours and then measured for resistance value (R_{A} and R_{B}, respectively) with the Loresta. Table 2 shows the ratio of the resistance value after the storing in the thermo-hygrostat for 250 hours to the resistance value before the storing (R_{A}/R₁ and R_{B}/R₁₀, respectively).

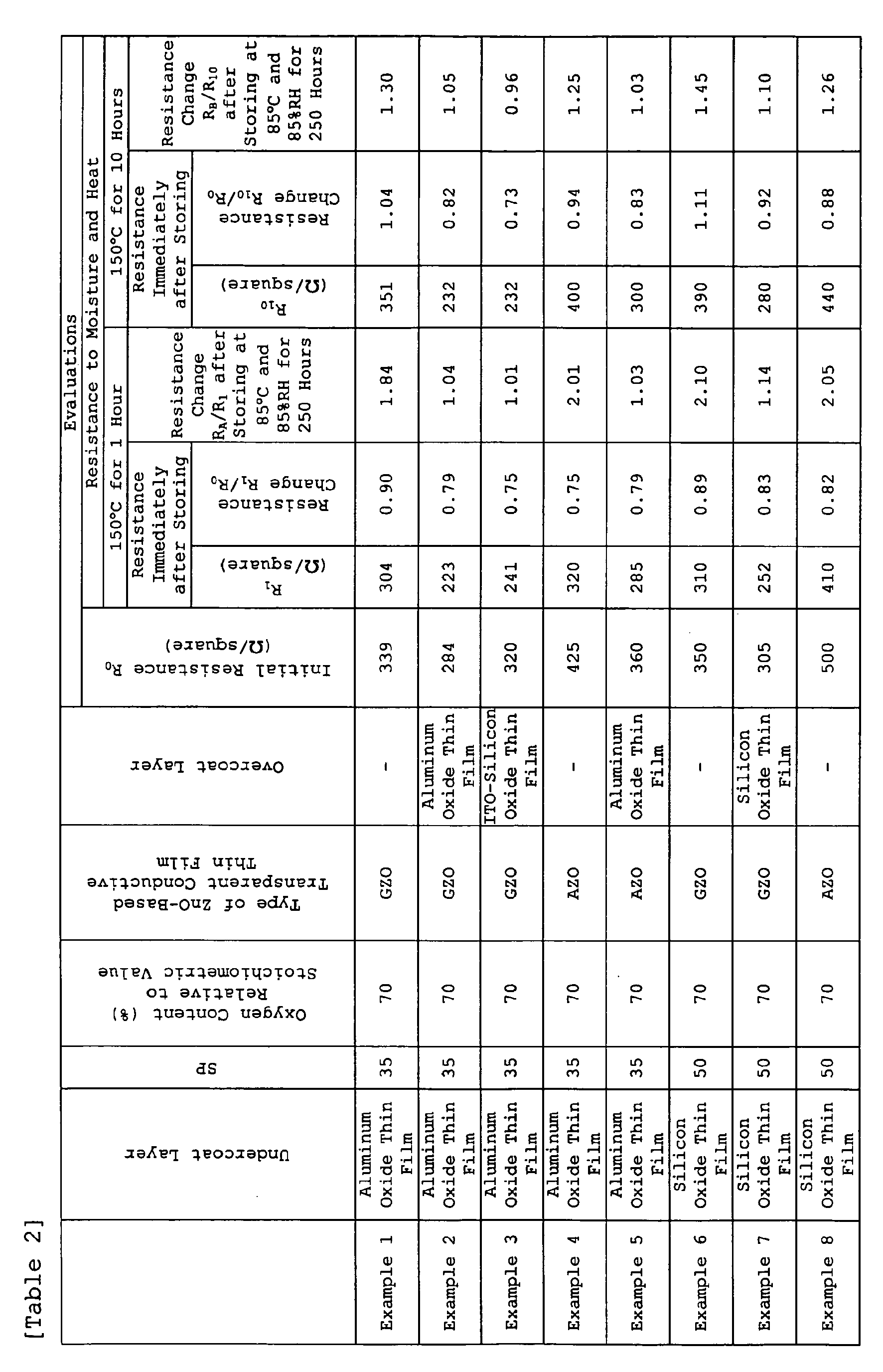

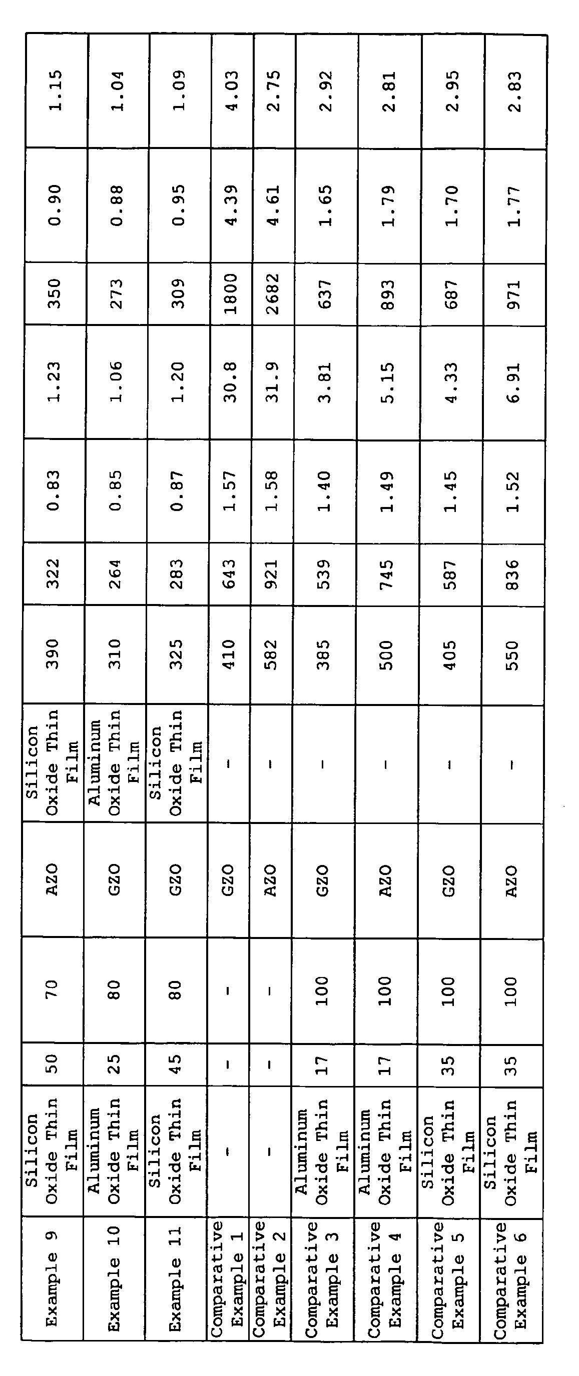

Table 2 shows that the initial resistance value is smaller in the Examples than in the Comparative Examples and that the resistance to moisture and heat is improved in the Examples. It is also apparent from Examples 2, 3, 5, 7, and 9 to 11 that when an overcoat layer having moisture-proof properties is formed, a lower resistance value is obtained, and the resistance to moisture and heat is further improved.

## Claims

1. A transparent conductive film, comprising:
an organic polymer film substrate;
a first oxide thin film with a high visible-light transmittance formed on the organic polymer film substrate; and
a ZnO-based transparent conductive thin film formed on the first oxide thin film, wherein
the first oxide thin film has an oxygen content corresponding to 60 to 90% of the stoichiometric value before the ZnO-based transparent conductive thin film is formed.

2. The transparent conductive film according to claim 1, wherein the resistance value of the ZnO-based transparent conductive thin film after heating in air at 150°C for 1 hour is 10% or more lower than the resistance value of it immediately after it is formed.

3. The transparent conductive film according to claim 1 or 2, wherein the ZnO-based transparent conductive thin film is a ZnO thin film doped with one or more elements selected from Al, Ga, B, and In.

4. The transparent conductive film according to any one of claims 1 to 3, wherein the first oxide thin film is an aluminum oxide thin film or a silicon oxide thin film.

5. The transparent conductive film according to any one of claims 1 to 4, further comprising a second oxide thin film with a high visible-light transmittance formed on the ZnO-based transparent conductive thin film.

6. The transparent conductive film according to claim 5, wherein the second oxide thin film has a water-vapor transmission rate of 1.0 g/m² per day or less as measured by a MOCON method under the conditions of an atmosphere temperature of 40°C and a relative humidity of 90%.

7. The transparent conductive film according to any one of claims 1 to 6, wherein the ZnO-based transparent conductive thin film has a thickness of 10 nm to 100 nm.

8. A method for producing the transparent conductive film according to any one of claims 1 to 7, comprising forming the first oxide thin film by a reactive dual magnetron sputtering method.
